# EUROPÄISCHE PATENTSCHRIFT

(11) **EP 1 870 946 B1**
(45) Veröffentlichungstag und Bekanntmachung des Hinweises auf die Patenterteilung: **22.09.2010**
(21) Anmeldenummer: 07006204.7
(22) Anmeldetag: 27.03.2007
(51) Int. Cl.: H01L 35/00, H01L 35/30, F28D 15/02

(54) **Autonome thermoelektrische Stromquelle mit geringen Abmessungen**
Autonomous thermo-electric source of electricity with small dimensions
Source d'énergie thermoélectrique autonome à dimensions réduites

(30) Priorität: 21.06.2006 RU 2006122286
(43) Veröffentlichungstag der Anmeldung: 26.12.2007
(73) Patentinhaber: Otkrytoe Aktsionernoe Obschestvo "RIF", 394062 Woronesh (RU)
(72) Erfinder: Ivanov, Aleksandr Sergejevich, 394000 Woronesh (RU); Kichik, Sergej Aleksandrovich, 394062 Woronesh (RU); Nikolajev, Juri Neonovich, 394053 Woronesh (RU); Prilepo, Juri Petrovich, 142531 Gebiet Moskau (RU); Tschernyschova, Tatjana Ivanova, 394006 Woronesh (RU); Varlamov, Sergej Anatoljevich, 394000 Woronesh (RU)
(74) Vertreter: Richter, Joachim

(56) Entgegenhaltungen:
- DE-A1- 2 640 676
- JP-A- 53 119 456
- RU-C1- 2 099 642
- US-A- 3 143 592
- US-A- 4 125 122
- US-A1- 2001 018 967

## Beschreibung

Die Erfindung bezieht sich auf die Schaffung von thermoelektrischen E-lektroenergiequellen, die auf dem Seebeck-Effekt basieren, insbesondere auf autonome thermoelektrische Gleichstromquellen mit geringen Abmessungen, die zum Einsatz als Elektroenergiequelle geringer Leistung zur autonomen Versorgung unterschiedlicher Vorrichtungen (Nachrichtenmittel, Akkumulatoren, Haushaltsrundfunk- und Fernsehgeräte) bestimmt sind, die sich in schwer zugänglichen und entfernten Gebieten der Erde befinden, für die komplizierte und unbeständige meteorologische Bedingungen mit starken Wärme- und Kälteschwankungen, erhöhter Feuchtigkeit und enormer Trockenheit sowie Magnetstürme kennzeichnend sind.

Für diese schwierigen Bedingungen ist eine autonome Stromquelle mit besonderen stabilen mechanischen und Temperatureigenschaften erforderlich, die ihren störungsfreien und zuverlässigen Betrieb gewährleisten und geringe Abmessungen und Gewicht besitzen, um sie bequem zu transportieren, z. B. im Rucksack von Rettungsmannschaften.

Die Schaffung einer derartigen autonomen Stromquelle mit geringen Abmessungen ist gegenwärtig eine höchst aktuelle Aufgabe, da die weithin bekannten autonomen thermoelektrischen Stromquellen unterschiedlicher Konstruktion in der Regel große Abmessungen und ein großes Gewicht haben und nicht zuverlässig genug im Betrieb unter Extrembedingungen sind (sie haben Störungen und fallen aus).

So ist eine Vorrichtung zur Stromversorgung (Patent RF Nr. 2166223, veröffentlicht am 27.04.2001, M. KI. H01L ³⁵/₀₀) bekannt, die für die Notstromversorgung von Objekten der landwirtschaftlichen Produktion bestimmt ist und einen Temperaturgeber in Form einer Thermobatterie, eine Stromabnahmestück, Stromleiter und Kältespeicher enthält. Das Vorrichtungsgehäuse hat eine innere Trennwand, die den Rauminhalt in zwei Teile teilt. In einem Teil befinden sich die Brennkammer und die Heißlötstellen des Temperaturgebers, im anderen Teil die Kaltlötstellen des Temperaturgebers, die mit Luft und Wasser aus dem Eiswasserspeicher gekühlt werden.

Ein Mangel dieser Vorrichtung ist seine ungenügende Betriebszuverlässigkeit, da die Konstruktion die Heißlötstellen der Thermobatterie nicht gleichmäßig und intensiv erhitzt und ihre Kaltlötstellen nicht im erforderlichen Maß kühlt. Die Vorrichtung hat große Abmessungen und ein großes Gewicht.

Ebenso bekannt ist der thermoelektrische Generator (Urheberschein UdSSR Nr. 439252, M. KI. H01 L ³⁵/₀₂, veröffentlicht am 05.08.1978, Blatt Nr. 29), der ein thermoelektrisches Modul, eine Brennvorrichtung und ein Wärmeabgabesystem in Form des Kühlmantels und der Kühlkörper enthält. Die Vorrichtung ist mit einem Turbulenzverstärker ausgestattet, der als Drahtspirale ausgeführt und zwischen Überzug und Kühlmantel angeordnet ist. Dadurch wird die Wärmeübertragung an den zu heizenden Raum verbessert. Es ist jedoch nicht möglich, in dieser Vorrichtung Strom in einer akzeptablen Größe zu erzeugen, da das Problem der Entstehung großer Temperaturgradienten zwischen den Heiß- und Kaltlötstellen des Thermomoduls nicht gelöst ist.

Bekannt ist auch eine Vorrichtung zur Erzeugung von Wärme- und Elektroenergie (Patent RF Nr. 2224190, M. Kl. F25B²¹/₀₂, veröffentlicht am 20.02.2004), die einen Brenner, Wärmeaufnehmer, Thermobatterien, ein Wärmeableitungssystem und einen Kraftrahmen enthält. Bei dieser Vorrichtung ist die Aufgabe der Verbesserung der Wärmeableitung unter Nutzung der Wärme der Verbrennungsprodukte durch Schaffung eines aus zwei Teilen bestehenden, konstruktiv komplizierten und robusten Wärmeableitungssystems gelöst.

Die Probleme höherer Zuverlässigkeit, großer Abmessungen und großen Gewichts sowie unbequemen Transports der Vorrichtung sind jedoch nicht gelöst, was beträchtliche Schwierigkeiten bei ihrem Einsatz unter Extrembedingungen verursacht.

Technisch am nächsten kommt dem Anmeldungsgegenstand der thermoelektrische Umformer von Wärmeenergie in elektrische Energie, der eine Baugruppe des thermoelektrischen Generators darstellt, der aus dem Patent RF Nr. 2099642 (M. KI. F24D⁰³/₀₈, veröffentlicht am 20.12.1997) bekannt ist.

Der thermoelektrische Umformer von Wärmeenergie in elektrische Energie stellt Thermobatterien dar, bei denen die "heiße" Seite mit dem Kondensationsteil des Thermosiphons verbunden ist und die "kalte" Seite mit dem Wärmetauscher. Die Elektroenergie wird über eine elektrische Herausführung abgeleitet.

Das Gewicht des thermoelektrischen Generators beträgt 150 kg. Er ist in ein Einbaugehäuse von 500 x 500 x 2000 mm eingebaut (ohne Wärmeverwertungssystem). Thermoelektrische Generatoren mit einer derartigen Konstruktion werden an Hauptrohrleitungen in großer Entfernung an schwer zugänglichen Stellen des Hohen Nordens installiert. Das stellt eine Wärmeversorgung ohne Unterbrechungen und die Stromversorgung des Kathodenschutzes sicher und senkt die Transportkosten bei Instandhaltung und Reparatur beträchtlich.

Dabei verfügt diese bekannte Konstruktion dank ihrer Konstruktionsbesonderheiten, die darin bestehen, dass die Wärmeenergie nur auf eine begrenzte innere Fläche trifft, nicht über genügend Festigkeitseigenschaften, wodurch ihre Betriebszuverlässigkeit unter Extrembedingungen verringert wird und sie schneller den Dienst versagt. Da die Vorrichtung schwer ist (150 kg), ist ein Transportmittel erforderlich, was unter Extrembedingungen dazu führt, dass ihr Betrieb beschwerlich ist.

Die technische Aufgabe bestand darin, eine in konstruktiver Hinsicht originelle thermoelektrische Stromquelle mit geringen Abmessungen zu schaffen, deren Konstruktion sich gegenüber den bekannten durch höhere Festigkeitseigenschaften (besonders eine höhere Wärmebeständigkeit), geringere Abmessungen und geringeres Gewicht zum bequemen Transport, z. B. im Rucksack, sowie durch eine hohe Zuverlässigkeit unter Extrembedingungen auszeichnet.

Dabei sollten folgende technisch-ökonomischen Werte gewährleistet werden:
- verbesserte technische und Betriebseigenschaften;
- hohe Zuverlässigkeit;
- Möglichkeit des Betriebs unter Extrembedingungen;
- hoher Schutz vor Havarien unter Extrembedingungen;
- lange störungsfreie Lebensdauer.

Es wird eine autonome thermoelektrische Stromquelle mit geringen Abmessungen vorgeschlagen, die ein im Gehäuse installiertes, teilweise mit einem flüssigen Wärmeträger gefülltes Gravitations-Wärmerohr einschließt, das einen unteren Verdampfungsteil mit gerippten Wärmeaufnahmerohren, die in der Heizzone des Wärmeträgers angeordnet sind, sowie einen mittleren Transportteil mit einer Transportzone für den Wärmeträger und einen oberen Kondensationsteil mit Kühlzone für den Wärmeträger besitzt, auf deren Fläche eine Thermobatterie installiert ist, die elektrische Verbindungen hat, die zur Steckvorrichtung für den Anschluss eines Verbrauchers führen. Dabei ist zwischen der Innenwand des Gehäuses und der Außenfläche der Thermobatterie ein Rohrkanal für die Zirkulation der Kühlflüssigkeit ausgeführt.

Die genannten technischen Ergebnisse werden dadurch erreicht, dass die Vorrichtung mit einer zwischen Hülsenverbindungsmuffe und konischer Endmuffe befestigten zentralen hohlen Stützsäule versehen ist, die unter dem unteren Ring des mittleren Transportteils des Gravitations-Wärmerohrs installiert ist. Das erwähnte Ende dieses Rohrs ist fest mit der freien Seite der Anschlussöffnung der Hülsenverbindungsmuffe verbunden, an deren Seitenfläche eine zusätzlich eingeführte Rejektorblende befestigt ist, die die Form einer flachen Scheibe mit zentraler Aufnahmebohrung hat. Darüber sind zusätzliche wärmestreuende Rejektorlamellenblenden angeordnet, die an Stäben befestigt sind, die mit dem Boden des Gehäuses, der über den genannten Blenden liegt, fliegend verbunden sind. Dabei sind die Wärmeaufnahmerohre in Form von Bögen ausgeführt, die rotundenförmig um die zentrale Säule angeordnet und durch die oberen und unteren Enden mit den Durchgangslöchern in den Seitenflächen der entsprechenden Muffen verbunden sind, wobei die Verrippung an den Wärmeaufnahmerohren in Form von auf ihnen aufgesteckten Scheiben ausgeführt ist.

Die Erfindung wird anhand der folgenden Zeichnungen näher erläutert:
- Fig. 1 - autonome thermoelektrische Stromquelle mit geringen Abmessungen (Gesamtansicht);
- Fig. 2 - ebenfalls, oberer Teil im Schnitt;
- Fig. 3 - ebenfalls, unterer Teil im Schnitt;
- Fig. 4 - ebenfalls, strukturelles Funktionsschema;
- Fig. 5 - Erprobung der autonomen thermoelektrischen Stromquelle mit geringen Abmessungen;
- Fig. 6 - Fotografie der autonomen thermoelektrischen Stromquelle (Ansicht von vorn).

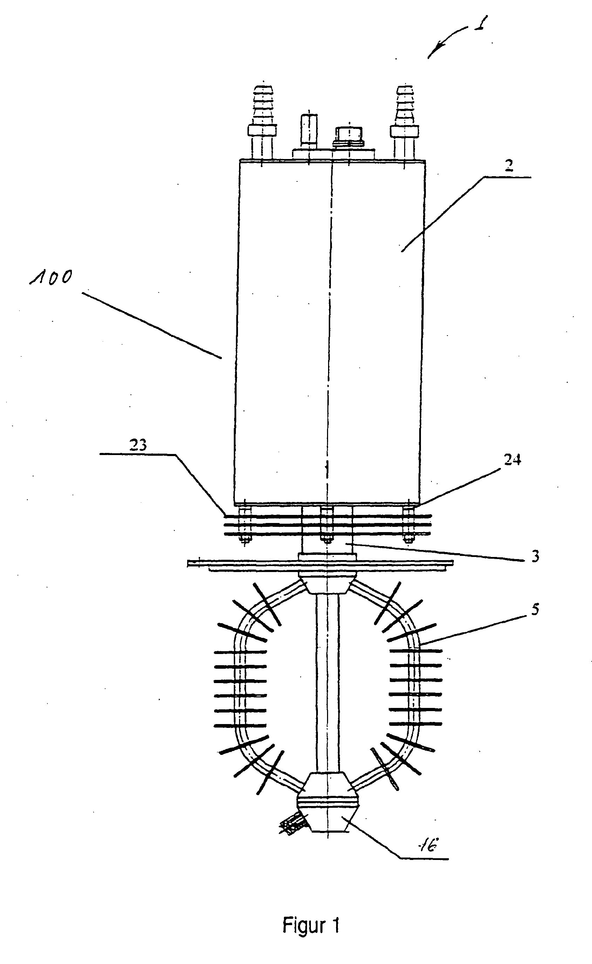

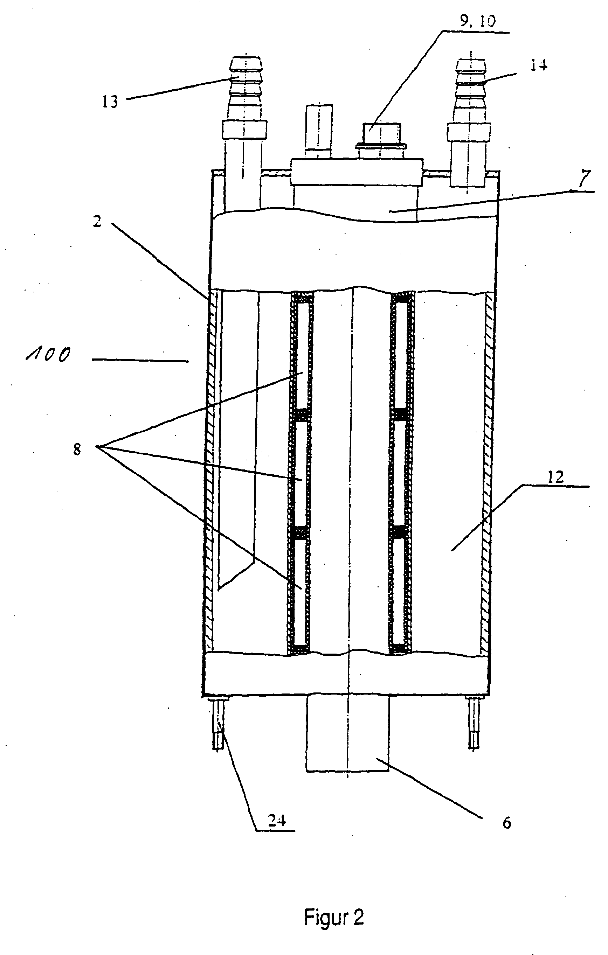

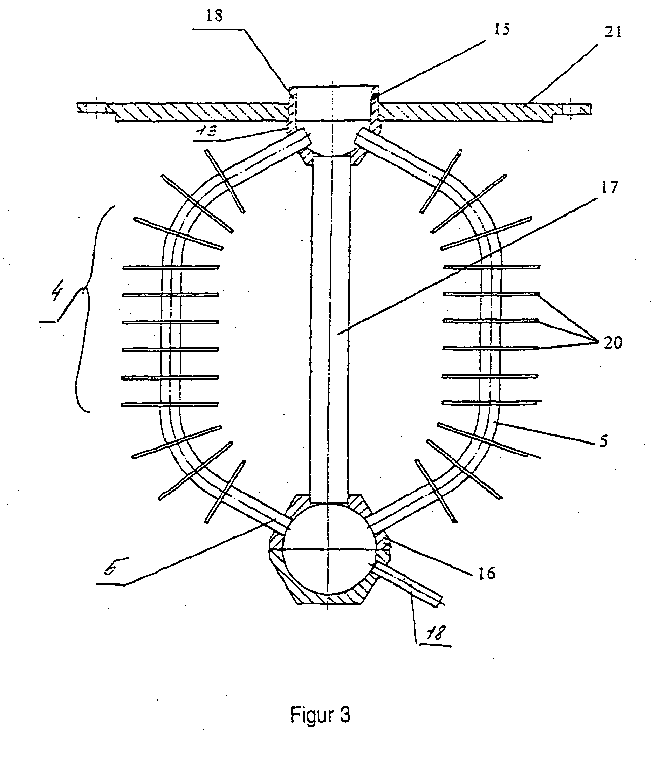

Die beanspruchte autonome thermoelektrische Stromquelle mit geringen Abmessungen 1 (s. Fig. 1-6) enthält ein im Gehäuse 2 installiertes, teilweise mit Wärmeträger, z. B. Wasser, gefülltes Gravitations-Wärmerohr 3, das einen unteren Verdampfungsteil 4 mit gerippten Wärmeaufnahmerohren 5 (Fig. 1, 3), die in der Heizzone für den Wärmeträger angeordnet sind, einen mittleren Transportteil 6 mit einer Zone des Wärmeträgertransports und einen oberen Kondensationsteil 7 mit einer Kühlzone für den Wärmeträger (Kondensation) besitzt, an deren Oberfläche eine Thermobatterie 8 angeordnet ist, die elektrische Anschlüsse 9 hat, die zur Steckverbindung 10 für den Anschluss eines Verbrauchers führen. Zwischen der Innenwand des Gehäuses 2 und der Thermobatterie ist ein Rohrkanal 12 für die Zirkulation der Kühlflüssigkeit gebildet, die über den Eintrittsstutzen 13 in ihn eintritt und über den Austrittstutzen 14 austritt. Die Stutzen 13 und 14 sind im oberen Teil des Gehäuses 2 installiert (Fig. 2).

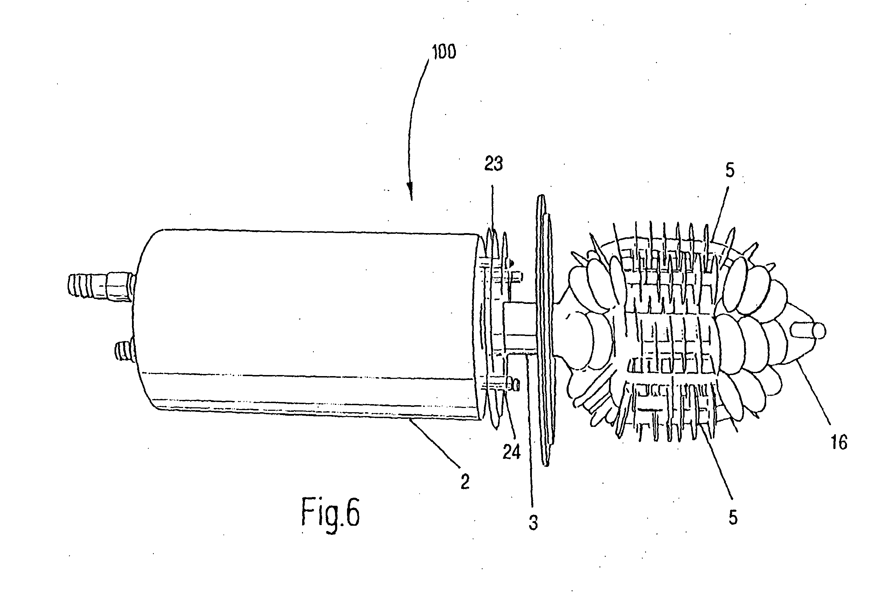

Die autonome thermoelektrische Stromquelle mit geringen Abmessungen 1 (Fig. 1, 3) ist mit einer zwischen der Hülsenverbindungsmuffe 15 und der konischen Endmuffe 16 befestigten hohlen Stützsäule 17 ausgestattet, die unter dem unteren Ende des mittleren Wärmeübertragungsteils 6 des Gravitations-Wärmerohrs 3 installiert ist. Das genannte Ende 6 dieses Rohrs ist mit der freien Seite der Axialöffnung der Hülsenverbindungsmuffe 15 fest verbunden. Die Hülsenverbindungsmuffe 15 hat eine profilierte Seitenaußenfläche, die aus einem zylindrischen oberen Teil und einem konischen unteren Teil gebildet ist. An der zylindrischen Seitenfläche der Muffe 15 ist eine zusätzlich in die Konstruktion eingeführte Hauptrejektorblende 21 befestigt, die die Form einer flachen Scheibe mit zentraler Aufnahmebohrung hat. Darüber sind zusätzlich eingebrachte Hilfsrejektorblenden 23 (Fig. 1) angeordnet, die an Stäben 24 befestigt sind, die mit dem Boden 25 des Gehäuses 2 fliegend verbunden sind. Die Wärmeaufnahmerohre 5 (Fig. 1, 3) sind in Form von Bögen ausgeführt, die rotundenförmig um die zentrale Stützsäule 17 (Fig. 6) angeordnet sind, dabei sind die Wärmeaufnahmerohre 5 mit ihren oberen und unteren Enden jeweils mit den Durchgangsbohrungen verbunden, die in den konischen Seitenflächen der Hülsenverbindungsmuffe 15 und der Endmuffe 16 ausgeführt sind. Das Wärmerohr 3 ist ein geschlossenes, zweiphasiges, evakuiertes Gravitations-Verdampferrohr ohne Docht.

Die Verrippung der Wärmeaufnahmerohre 5 ist in Form von darauf aufgesteckten Scheiben 20 ausgeführt. Die Befüllung des Wärmerohrs 3 mit flüssigem Wärmeträger erfolgt durch einen Nippel 18. Die oben beschriebene zusammengesetzte Konstruktion des Verdampfungsteils des Wärmerohrs 3 ermöglicht es, die Festigkeitseigenschaften der gesamten beanspruchten Konstruktion zu verbessern, da der Verdampfungsteil des Wärmerohrs ein verstärktes Montagegerüst ist (d. h. eine Skelettstruktur), das die Hauptlast aufnimmt und Festigkeit, Wärmebeständigkeit und Stabilität der Konstruktion insgesamt gewährleistet. Zugleich stellt diese Konstruktion sicher, dass die Wärmeaufnahmegesamtfläche durch eine originell ausgeführte Konstruktion des Verdampfungsteils vergrößert wird.

Durch diese Konstruktion wird die Effektivität der Wärmeaufnahme, die gleichmäßige Intensität der Erhitzung und der Verdampfung des flüssigen Wärmeträgers verbessert, wodurch ein gleichmäßiger und zuverlässiger Betrieb der Vorrichtung sichergestellt und die Wärmeenergie effektiver genutzt wird, wodurch eine hohe Effektivität der Umwandlung der Wärmeenergie in elektrische Energie gewährleistet wird.

Die zusätzlich in die beanspruchte Konstruktion der Vorrichtung eingebrachten Haupt- und Zusatzrejektorblenden 21 und 23 trennen den Verdampfungsteil vom Kondensationsteil des Wärmerohrs und ermöglichen es, den Einfluss des Luftwärmestroms auf den unteren Teil 25 des Gehäuses 2 auszuschalten. Dadurch wird es möglich, qualitative elektrische Energie stabil zu erzeugen und eine Überhitzung der Außenflächen des Gehäuses zu vermeiden.

Die hergestellte autonome thermoelektrische Stromquelle mit geringen Abmessungen verfügt über folgende technische Eigenschaften:

| | |
|---|---|
| Elektrische Ausgangsleistung, W | 60 |
| Ausgangsspannung, V | 12 |
| Abmessungen, mm | |
| Durchmesser | 180 |
| Länge | 760 |
| Masse, kg | 20 |
| Lebensdauer, Jahre | 20 |

Die beanspruchte Vorrichtung verfügt über so einzigartige Eigenschaften, wie vollständige Autonomie, hohe Zuverlässigkeit, einfacher Betrieb, hohe Nutzungsdauer, geringe Abmessungen, hohe Energiekennwerte und geringes Gewicht.

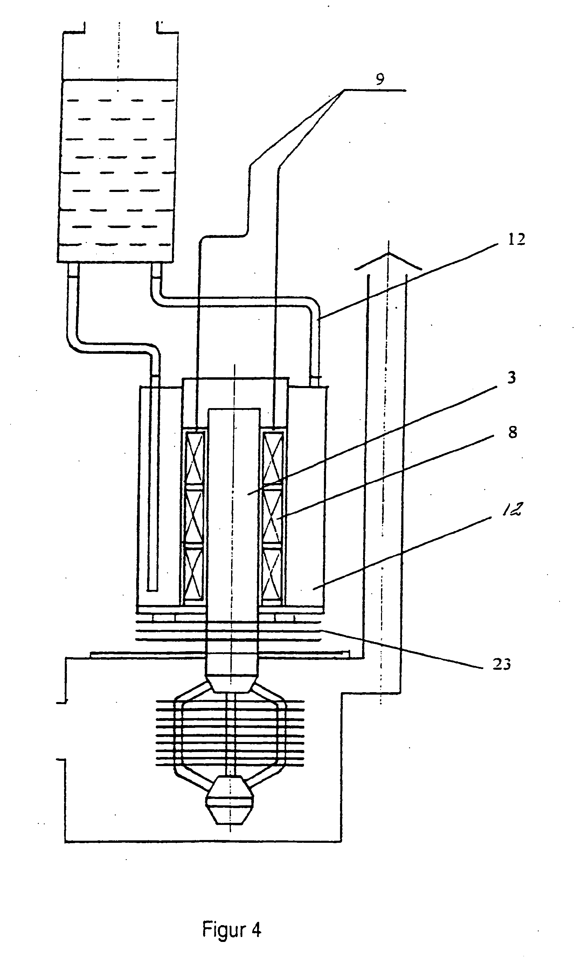

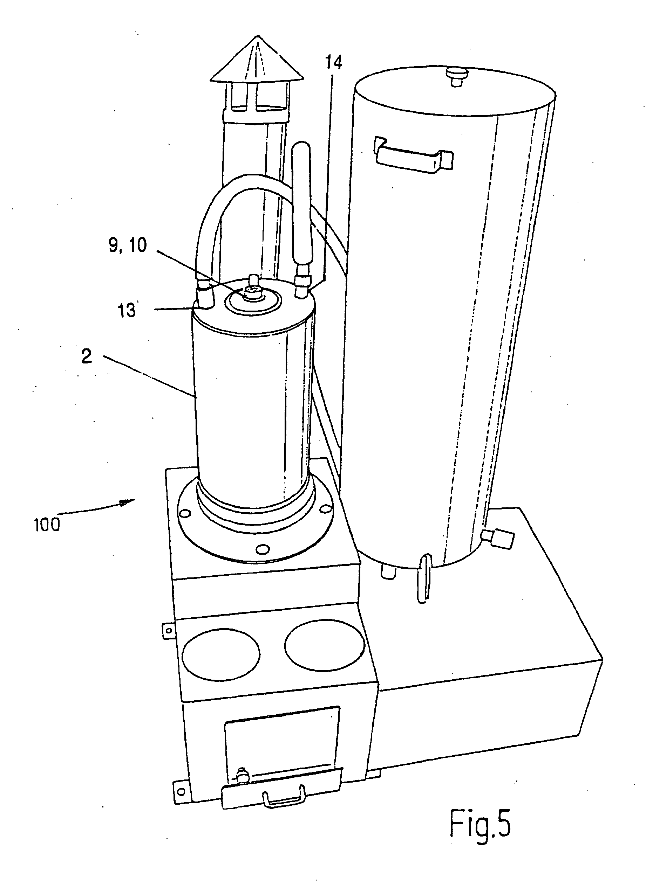

Die beanspruchte Vorrichtung funktioniert folgendermaßen (Fig. 4, 5). Die autonome Stromquelle mit geringen Abmessungen 1 wird senkrecht zur Säule durch die Hauptrejektorblende an einer Halterung angebracht, die über einer Wärmequelle installiert ist, z. B. über den Flammen eines (Lager-)Feuers (s. Fig. 5). Die Flammenzungen des (Lager-)Feuers dringen in die Zwischenräume zwischen allen Bauteilen des unteren Teils des Wärmerohrs ein und stellen eine gleichmäßig verteilte, maximal mögliche Wärmeaufnahme dieses Teils der Konstruktion sicher, indem sie sie erhitzen. Durch die Erhitzung wird die Verdampfung des flüssigen Wärmeträgers ausgelöst, der entstehende Dampf nimmt die Wärme auf und transportiert sie anschließend nach oben. Indem er im oberen Teil des Wärmerohrs kondensiert, gibt er sie ab. Der Wärmestrom erhitzt die heißen Seiten der Thermobatterie 8. Das im Kanal 12 zirkulierende kalte Wasser kühlt die kalte Seite der Thermobatterie 8. Der dabei entstehende elektrische Strom gelangt über die elektrischen Verbindungen zur Steckverbindung 10 für den Anschluss eines Energieverbrauchers.

Die beanspruchte Konstruktion der autonomen thermoelektrischen Stromquelle mit geringen Abmessungen bietet folgende technische Vorteile gegenüber bekannten Konstruktionen:
- verbesserte technische und Betriebseigenschaften;
- hohe Betriebszuverlässigkeit in einem breiten Spektrum klimatischer Bedingungen;
- bequemer Transport durch geringe Abmessungen und Gewicht;
- lange störungsfreie Lebensdauer.

### Bezugszeichenliste:

- 100: autonome thermoelektrische Stromquelle
- 1: Abmessungen
- 2: Gehäuse
- 3: Gravitations-Wärmerohr
- 4: unteres Verdampfungsteil
- 5: Wärmeaufnahmerohre
- 6: Transportteil
- 7: Kondensationsteil
- 8: Thermobatterie
- 9: elektrische Anschlüsse
- 10: Steckverbindung
- 12: Rohrkanal
- 13: Eintrittsstutzen
- 14: Austrittsstutzen
- 15: Hülsenverbindungsmuffe
- 16: Endmuffe
- 17: Stützsäule
- 18: Nippel
- 20: Scheiben
- 21: Hauptrejektroblende
- 23: Wärmestreuungsrejektorlamellenblenden
- 24: Stäbe
- 25: unterer Teil

## Patentansprüche

1. Autonome thermoelektrische Stromquelle (100) mit geringen Abmessungen (1), die ein im Gehäuse (2) installiertes, teilweise mit flüssigem Wärmeträger gefülltes Gravitations-Wärmerohr (3) enthält, das einen unteren Verdampfungsteil (4) mit verrippten Wärmeaufnahmerohren (5) , die in der Heizzone für den Wärmeträger angeordnet sind, sowie einen mittleren Transportteil (6) mit einer Transportzone des Wärmeträgers und einen oberen Kondensationsteil (7) mit Kühlzone für den Wärmeträger, mit einer auf ihrer Oberfläche angeordneten Thermobatterie (8) besitzt, die elektrische Verbindungen hat, die zur Steckverbindung (10) für den Anschluss eines Verbrauchers führen, wobei zwischen der Innenwand des Gehäuses (2) und der Außenfläche der Thermobatterie ein Rohrkanal (12) zur Zirkulation der Kühlflüssigkeit ausgebildet ist, **dadurch gekennzeichnet, dass** sie mit einer zwischen der Hülsenverbindungsmuffe (15) und der konischen Endmuffe (16) befestigten zentralen hohlen Stützsäule (17) ausgestattet ist, die unter dem unteren Ende des mittleren Transportteils (6) des Gravitations-Wärmerohrs (3) installiert ist, dessen erwähntes Ende mit der freien Seite der Verbindungsöffnung der Verbindungsmuffe (15) fest verbunden ist, an deren Seitenfläche eine zusätzlich eingeführte Hauptrejektorblende befestigt ist, die die Form einer Scheibe mit zentraler Aufnahmebohrung hat, und darüber zusätzliche Wärmestreuungsrejektorlamellenblenden (23) angeordnet sind, die an Stäben (24) befestigt sind, die fliegend mit dem Boden (25) des Gehäuses verbunden sind, der über den erwähnten Blenden liegt, dabei sind die Wärmeaufnahmerohre (5) in Form von Bögen ausgeführt, die rotundenförmig um die erwähnte zentrale Säule (17) angeordnet und mit den oberen und unteren Enden mit den Durchgangsbohrungen in den Seitenflächen der jeweiligen Muffen (15, 16) verbunden sind, wobei die Verrippung an den Wärmeaufnahmerohren (5) in Form von auf ihnen aufgesteckten Scheiben (20) ausgeführt ist.

## Claims

1. An autonomous thermoelectric power source (100) with small dimensions (1), which contains a gravitational heat pipe (3) which is installed in a housing (2) and filled to some extent with a liquid heat transfer medium and which has a lower evaporation part (4) with ribbed heat absorption pipes (5), which are arranged in the heating zone for the heat transfer medium, and also a central transport part (6) with a transport zone of the heat transfer medium and an upper condensing part (7) with cooling zone for the heat transfer medium, with a thermoelectric battery (8) arranged on its surface, which has electrical connections which lead to the plug connection (10) for the connection of a consumer, wherein a pipe channel (12) is constructed for the circulation of the cooling liquid between the inner wall of the housing (2) and the outer face of the thermoelectric battery, **characterised in that** it is equipped with a central hollow support column (17) which is fixed between the bush connection sleeve (15) and the conical end sleeve (16) and is installed below the lower end of the central transport part (6) of the gravitational heat pipe (3), the mentioned end of which is securely connected to the free side of the connection opening of the connection sleeve (15), to the side face of which an additionally inserted main rejector plate, which has the form of a disc with central receiving hole, is fixed and thereabove additional heat dissipation rejector lamellar plates (23) are arranged, which are fixed to rods (24) which are connected to the base (25) of the housing in a floating manner, which base is located above the mentioned plates, the heat absorption pipes are in this case realised in the shape of arcs which are arranged in the manner of a rotunda around the mentioned central column (17), the upper and lower ends of which arcs are connected to the through holes in the side faces of the respective sleeves (15, 16), wherein the ribbing on the heat absorption pipes (5) is realised in the form of discs (20) fitted on them.

## Revendications

1. Source de courant (100) thermoélectrique autonome présentant de faibles dimensions (1), qui contient un tuyau de chaleur par gravité (3) installé dans le boîtier (2), rempli en partie de caloporteur liquide, lequel tuyau présente une partie d'évaporation (4) inférieure avec des tuyaux d'absorption de chaleur (5) nervurés, qui sont disposés dans la zone de chauffage pour le caloporteur, et une partie de transport (6) centrale avec une zone de transport du caloporteur et une partie de condensation (7) supérieure avec zone de refroidissement pour le caloporteur, avec une thermopile (8) disposée sur sa surface supérieure, qui a des liaisons électriques qui aboutissent à la liaison à fiche (10) pour le raccordement d'un consommateur, un canal tubulaire (12) pour la circulation du liquide de refroidissement étant réalisé entre la paroi interne du boîtier (2) et la surface externe de la thermopile, **caractérisée en ce que** la source de courant est équipée d'une colonne de support (17) creuse, centrale, fixée entre le manchon de liaison de douille (15) et le manchon d'extrémité (16) conique, qui est installée sous l'extrémité inférieure de la partie de transport (6) centrale du tuyau de chaleur par gravité (3), dont l'extrémité mentionnée est reliée fixement au côté libre de l'ouverture de liaison du manchon de liaison (15), sur la surface latérale duquel est fixé un obturateur de réjecteur principal introduit en supplément, lequel a la forme d'un disque avec un perçage de logement central, et des obturateurs à lamelles de réjecteur de dispersion de chaleur (23) supplémentaires sont disposés au-dessus, lesquels sont fixés sur des barres (24), qui sont reliées de façon mobile au fond (25) du boîtier, lequel est disposé au-dessus des obturateurs mentionnés, les tubes d'absorption de chaleur (5) étant réalisés ici sous la forme de coudes qui sont disposés en forme de rotonde autour de la colonne (17) centrale mentionnée et sont reliées par les extrémités supérieures et inférieures aux perçages de passage dans les surfaces latérales des manchons (15, 16) respectifs, le nervurage étant réalisé sur les tuyaux d'absorption de chaleur (5) sous la forme de disques (20) emboîtés sur ces tuyaux.
